# EUROPEAN PATENT APPLICATION

(11) **EP 4 845 315 A2**
(43) Date of publication of application: **25.11.2026**
(21) Application number: 26179426.7
(22) Date of filing: 19.05.2026
(51) Int. Cl.: H05K 1/14, H05K 3/36, H05K 3/40, H05K 3/46

(54) **RIGID-FLEXIBLE PRINTED CIRCUIT BOARD AND MANUFACTURING METHOD THEREOF**

(30) Priority: 21.05.2025 IT 202500011497
(71) Applicant: Cisel - S.r.l. - Circuiti Stampati per Applicazioni Elettroniche, 60022 Castelfidardo (AN) (IT)
(72) Inventor: FIORETTI, Emanuela, 00185 ROMA (IT)
(74) Representative: Del Nero, Susanna

(57) **Abstract**

The invention relates to rigid-flexible Printed Circuit Board or PCB (100) for electronic applications, provided with conductive tracks, insulating layer, protective coating, optionally electronic components, comprising at least one rigid PCB (11) and at least one flexible PCB (21) capable of elastic deformation; when said flexible PCB undergoes a mechanical stress, it returns to its original shape when the applied stress is removed without any damage. A coupling area (16) of the rigid PCB (11) and a coupling area (26) of the flexible PCB (21) that are free from insulating layer (12, 22) and from protective coating (15, 25) so that the conductive layer (13, 23) is uncovered in both PCBs (11, 21) are positioned and coupled in register. The coupling area (26) of the flexible PCB (21) comprises a plurality of through holes (39). The coupling areas (16, 26) in the portion of rigid PCB and in the portion of flexible PCB intended for coupling are provided with a mirroring design. The mechanical and electrical connection between said two PCBs is provided through melted solder alloy (31), forming solder menisci (33) between the rigid PCB (11) and the flexible PCB (21).

The invention further comprises a method for the manufacturing of said rigid-flexible PCB.

## Description

The present invention relates to a rigid-flexible printed circuit board for electronic applications and manufacturing method thereof.

In particular, the rigid-flexible Printed Circuit Board (PCB) according to the present invention is provided with through holes in the flexible PCB, which are coupled in register with corresponding coupling areas provided in the rigid PCB. Through said holes a soldering is performed through known techniques, so obtaining a working rigid-flexible PCB. The soldering performed on the PCBs technically is a soft soldering in that is uses an alloy forming intermetallic compounds with the two to-be-united parts.

In an embodiment, the soldering is performed by using a known solder paste; the solder paste is successively melted. For solder paste the paste presently used in the soldering of electronic components in Surface Mount Technology (SMT) is meant.

In an alternative embodiment, the soldering is performed by using the solder alloy in the form of wire; this, too, is a well-known technique in the art, through manual soldering or through an automatic machine provided with a robotic arm.

### State of the art

The printed circuit board for electronic applications (in the following indicated as printed circuit board) was invented by German Albert Hanson, who in 1903 filed the patent application CH29759A claiming a flat conductor applied to multi-layer insulating board. Only after 1960 the miniaturization of components and consequently of products required the adoption of printed circuit in the industry as standard solution for assembling printed circuit boards. Examples of such technology can be found in the printed circuit boards commonly used in radios, TV sets, computers and in sundry industrial devices. These circuits are still widely used, are rigid and comprise at least one layer of insulating material, typically resin-impregnated mineral fibres, coupled with at least one layer of conductive material, typically copper, on which layer of conductive material a drawing of the circuit to be produced is printed through a serigraphic or photographic process. Such circuit is successively etched through a chemical process, so obtaining all the paths of the single conductive tracks needed for the functions to be performed, typically interconnections of electronic components to each other and toward external circuits.

A rigid PCB normally comprises one or more alternated layers of insulating material and of conductive material, wherein the insulating material can be of different kind: nowadays, in most of applications mineral fibre fabrics impregnated with epoxy or polyimide resins are used; in some cases, also ceramic supports are used (alumina Al₂O₃, or beryllium oxide BeO), having thicknesses ranging 100 µm up to some millimetres. The conductive material is normally electrolytic copper with thicknesses ranging 15 to over 200 µm, but in some applications other metals like aluminium or special alloys (e.g. Costantana) are used. As seldom the thickness of the desired printed circuit corresponds to the sum of the thickness of the layers thereof, generally additional layers of insulating materials are added, in order to reach the desired measure. In the case of circuits having more than two conductive layers, the single layers are singly prepared and etched in order to obtain the desired electrical tracks, and successively coupled in register and hot-pressed, so obtaining a monolithic sandwich. The interconnections between layers are obtained by means of internally metallized through holes or blind holes. In the known technique they are initially coated with a conductive polymer, e.g. 3,4 ethylenedioxythiophene or a resin comprising cations, like Sn²⁺; on such conductive polymer, a galvanic copper growth is performed. Finally, the printed circuit is usually protected through a serigraphycally or photographically applied layer known as solder resist, which leaves uncovered only the areas wherein the soldering of components and connections are to be performed. Such coupling areas, in their turn, are usually protected from oxidation and in order to promote their solderability through chemical or galvanic coatings, like tin, nickel, gold, silver alloy or organic polymer (OSP) deposition.

Alternatively, to the above-mentioned substrates, a layer made of aluminium, copper or metallic alloys suitable for dissipating the heat generated by electronic components can be used. Typically, this is made in the automotive and lighting sectors, wherein components generating a lot of heat are used.

Since about 1980 the technology of so-called flexible printed circuits has started to spread, which uses a subtle layer of insulating material, typically but not exclusively polyester or polyamide, in lieu of resin-impregnated mineral fibres. This kind of circuits is advantageous when sundry parts of a complex electronic circuit have to be positioned in mechanically non-coplanar positions, or in non-rigidly connected positions. E.g., think of the electronic circuits placed behind a car's dashboard, or the electronic circuit inside cameras. Such circuits sometimes can undergo repeated bending, like in the connection between mother board and display in portable laptops or in some mobile telecommunication terminals (e.g. StarTAC^{®} Motorola) that can be flipped when not in use.

Analogously, a flexible printed circuit is normally made of one or more alternated layers of insulating material and conductive material, wherein the insulating material can be of sundry type; generally, supports based on polyester like polyethylene (PE), polyethylene terephthalate (PET) polyethylene naphthalate (PEN) polytetrafluoroethylene (PTFE) or polyamide-based materials like e.g. polyimide (PI) film (commercial name Kapton), having thicknesses ranging 15 to about 200 µm. For flexible circuits, too, the conductive material is normally electrolytic copper having thicknesses ranging 15 up to 105 µm, but in some applications other metals like aluminium or special alloys (e.g. Costantana) are used. In the case of flexible printed circuits having more than two conductive layers, the single layers are singly prepared and etched in order to obtain the desired electrical tracks, and successively coupled in register and hot-pressed, so obtaining a monolithic sandwich. The interconnections between layers are obtained by means of internally metallized through holes or blind holes. In the known technique they are initially coated with a conductive polymer, e.g. 3,4 ethylenedioxythiophene or a resin comprising cations, like Sn²⁺; on such conductive polymer, a galvanic copper growth is performed. Finally, the printed circuit is usually protected through a last insulating layer, typically of the same kind of the insulating support, but possibly having a different thickness, which leaves uncovered only the areas wherein the soldering of components and connections are to be performed. Such coupling areas, in their turn, are usually protected from oxidation and in order to promote their solderability through chemical or galvanic coatings, like tin, nickel, gold, silver alloy or organic polymer (OSP) deposition. In order to preserve the desired flexibility, although technically they can be produced, flexible circuits with a very high number of conductive layers are normally not produced.

In the art, the coupling of a rigid PCB and of a flexible PCB is known: a typical, but not exclusive example is the use in some liquid crystal displays (LCD) wherein the part of circuit bearing the display and the relative driver circuit is rigid, while a flexible protrusion allows the direct connection of the main board on the printed circuit, preventing a complex and delicate cabling through wires.

When the features of a rigid PCB must be combined with those of a flexible PCB, in the known art typically the connection between the rigid PCB and the flexible PCB is performed by lamination. The known production technique consists in laminating together and hot-pressing at least a layer realized through a rigid substrate and at least one layer realized with flexible laminate, optionally performing a selective deposition of the adhesive layer, so that the board can be handled as a whole and assembled like a normal rigid PCB; after the assembling of electronic components the parts wherein the laminates are not glued together can be separated, so obtaining a circuit wherein the rigid parts and the flexible parts are intimately united to form a unique electronic board. Rigid-flexible PCBs are particularly advantageous in those electrical circuits, often miniaturized, wherein the various parts are not co-planar, e.g. inside photo- and video cameras, or in the mother board and display of a cellular phone or a tablet, etc.

The use of a rigid printed circuit board is particularly advantageous when electronic components have to be assembled on it; the flexible circuit board instead allows to reach and connect non-co-planar parts or non-rigidly connected parts of machines. Therefore, the so-called rigid-flexible circuit can be advantageous in many cases, but has the disadvantage of summing the cost of the rigid circuit part and the cost of the flexible circuit part, extended to the whole surface of the electronic board to be produced, in that during manufacturing the machines are obliged to work on a surface comprising a whole rigid printed circuit and a whole flexible printed circuit completely overlapping. Once the union of the two circuits has been performed, from the rigid-flexible all the non-desired parts of the circuit must be removed, which are discarded at the end of the process: this entails an evident waste of material, in particular of expensive copper plates.

A second disadvantage lies in the maximal dimensions obtainable with a traditional rigid-flexible circuit, realized by coupling and working plates: such circuit typically cannot exceed 600 x 1000 mm or little more, due to the limitations imposed by the machines used for manufacturing, in particular by laminating presses.

Vice-versa, a flexible printed circuit can be realized through continuous cycle machines (also known as roll-to-roll), wherein the production cycle is performed on machines unwinding the coils with the materials to be assembled, performing continuously coupling, lamination, photographic exposition, development, etching, etc. up to the optical inspection and to the electric test, rewinding the obtained flexible circuit to form a final coil of product, therefore realizing flexible printed circuits having theoretically even very high lengths, often of several metres, and potentially up to the whole length of the coils of base material.

Regrettably the rigid-flexible combination normally excludes the possibility of realizing printed circuits of wide dimensions due to the limitations linked to the peculiarities of production of rigid circuits.

WO 2024126042 A1 proposes to realize the rigid and the flexible printed circuit boards separately, to couple them through a laser welding process between dedicated areas pre-set in the flexible circuit and corresponding areas in the rigid circuit, solution requiring the pre-formation of the flexible printed circuit board in the part wherein the welding joint is realized, and the availability of a laser equipment. Moreover, it is to be noted that the machines required to perform such laser welding are extremely expensive and not normally available in factories producing electronic boards. Finally, the quality of the welding cannot be verified through a simple visual inspection; the rigid-flexible circuit must undergo an X-ray test or sample destructive tests.

CN 116 669 330 A describes a process for manufacturing an assembly formed by a one-sided rigid PCB and a flexible PCB. The two circuits are realized separately and then coupled through an adhesive, and pressed together. Successively, in the two coupled and pressed circuits, through holes are realized, wherein a solder material is pushed.

### Description of the invention

Aim of the present invention is realizing a rigid-flexible PCB free from the above-mentioned drawbacks, cheap to product thanks to the simplification of the process and to the minimization of processing waste.

A further aim of the present invention is that on the rigid-flexible PCB a simple visual inspection can be performed in order to verify the good quality of the connections between the rigid and the flexible PCBs.

Such aim is reached through a rigid-flexible PCB having the features defined in claim 1 and a processing method of said PCB having the features defined in claim 10.

According to the present invention, the rigid PCB and the flexible PCB are realized separately performing all the production steps according to the known technique of the two respective circuits, which PCBs are assembled successively through a soldering performed in an opportunely pre-set coupling area. According to the present invention, the coupling area present on the flexible PCB is provided with a plurality of through holes through which a soldering is performed between the uncovered area of the flexible PCB and the underlying area of the rigid PCB, so permanently connecting the rigid PCB to the flexible PCB. In this way, a PCB having the features of rigidity of the part of the rigid PCB and of flexibility in the flexible part can be obtained, capable of being repeatedly deformed during use without damages and without losing functionality, preventing the waste of a wide surface of rigid circuit which normally is removed and discarded after lamination and assembly. Moreover, this allows to exceed the dimensional constraints imposed by processing machines, through the separate realization of the rigid part and of the flexible part and their successive assembling to form a unique body.

Hence, said rigid-flexible PCB can have dimensions as large as desired, wherein the constraints due to the production machines for the rigid part do not extend to the flexible part. The overall cost of the assembly is much cheaper than the cost of a traditional rigid-flexible PCB obtained through joint lamination of both parts, in that the scrap of the rigid PCB is prevented, that has to be detached and discarded to free the flexible PCB.

Several thermoplastic materials, polymeric films and assemblies of films and impregnated materials can be used as base supports to produce PCBs, as long as several composite materials. Each material is provided with its own mechanical and thermal features, determining deformability, elasticity and thermal features. It is up to the skilled person to decide the detail of such embodiments, focusing on the specificity of the design and of the coupling, which anyway is to be fine-tuned in single cases and for the chosen mechanical specifications.

The method for making a rigid-flexible PCB according to the present invention comprises the following steps:
a) providing said rigid PCB according to the known art, wherein in the coupling portion suitable coupling areas are provided having determined shape and dimensions;
b) providing said flexible PCB according to the known art, wherein in the coupling portion suitable coupling areas are provided having determined shape and dimensions, mirroring those provided on the portion of the rigid PCB;
c) providing at least a through hole on the areas of the flexible PCB intended for coupling with the rigid PCB;
d) placing said rigid PCB and said flexible PCB so that the coupling areas are kept in the correct reciprocal in-register position,
e) applying on the coupling areas intended for coupling a suitable quantity of solder alloy and bringing it to melting, and successively cooling to room temperature.

In an embodiment, the solder alloy is provided in the form of soldering paste; in an alternative embodiment, the solder alloy is provided in the form of wire.

It is worth specifying that in case of soldering performed with solder paste, the order of operation is first applying on the coupling areas intended for coupling a suitable quantity of solder paste and successively placing said rigid PCB and said flexible PCB so that the coupling areas are kept in the correct reciprocal in-register position. Vice versa, in the case of soldering performed with wire, the order of operation is first placing said rigid PCB and said flexible PCB so that the coupling areas are kept in the correct reciprocal in-register position, and successively applying on the coupling areas intended for coupling a suitable quantity of solder alloy in form of wire. The soldering in this case is performed manually or through a robotic arm, and the solder alloy applied through wire penetrates from the overlaying flexible PCB to the underlaying rigid PCB forming a column and connecting them in an electrically and mechanically robust way.
a preferred embodiment, the rigid PCB and flexible PCB are maintained in register in a desired position through the interposition of a layer of adhesive or glue and/or through mechanical coupling means for the time needed for the subsequent working.

The present invention is provided with manifold advantages.

The first advantage consists in preventing the waste of base material (i.e. rigid PCB and flexible PCB) due to the overlaying of the rigid PCB and the flexible PCB that occurs in the traditional lamination technique, requiring to use a sandwich of materials as big as the entire plate. The present invention allows to obtain rigid-flexible PCBs that are cheaper with respect to those obtained according to the known art, especially when the dimensions of the part of flexible PCB are prevalent with respect to the part of rigid circuit.

The second advantage is given by the reduction in the number of working steps and lower use of auxiliary materials. In fact, in the pressing step according to the known art auxiliary materials are used (special cardboard, release material, etc.) which are not part of the final product, but are anyway used and contribute to the cost of the final product. If pressing is performed just to produce the rigid PCB, and therefore a small part of the final PCB, a lower quantity of those materials is used.

The third advantage lies in exceeding the dimensional limits of the machines used for producing rigid PCBs, especially of the hydraulic presses used for coupling the rigid PCB with the flexible PCB.

The fourth advantage is that the method according to the present invention is realisable in a simple and cheap way through the normal equipment commonly used for producing PCBs like dosers, serigraphic machines and reflow ovens, when solder paste is used. When the solder paste is provided in the form of wire that is manually soldered or soldered through a soldering machine provided with a robotic arm, the passage in a reflow oven is prevented, which entails an energy saving and hence cost saving, and moreover prevents a further thermal stress to the rigid-flexible PCB and to its electronic components.

The fifth advantage is that the rigid-flexible PCB can be simply visually inspected in order to verify that the soldering process has been successful.

The sixth advantage is that, with the present invention, PCBs wherein the rigid PCB is made of a ceramic material can be realized, which, being fragile, cannot withstand the pressing step.

The seventh advantage is that with the present invention, more than one flexible PCBs can be positioned on the same rigid PCB, optionally even to both faces of the rigid PCB.

With respect to the method proposed in WO 2024126042 A1, a further advantage is preventing the use of an expensive laser soldering machine for soldering the rigid PCB and the flexible PCB.

### Description of figures

These and other features of the present invention will become more apparent from the following detailed description of some practical embodiments thereof, shown by way of non-limiting examples in the accompanying drawings, in which:
figure 1 shows an example of rigid-flexible PCB according to the known art;
figure 2A shows, in a schematic way and not to scale, an axonometric view of an example of rigid PCB meant for coupling with the flexible PCB of figure 3;
figure 2B shows, in a schematic way and not to scale, a sectional view of an example of rigid PCB meant for coupling with the flexible PCB of figure 3;
figure 3A shows, in a schematic way and not to scale, an axonometric view of an example of flexible PCB meant for coupling with the rigid PCB of figure 2;
figure 3B shows, in a schematic way and not to scale, a sectional view of an example of flexible PCB meant for coupling with the rigid PCB of figure 2;
figure 4A shows the coupling of the rigid PCB and the flexible PCB in an axonometric view;
figure 4B shows a section of the coupling, in an exploded view;
figure 4C shows a section of the coupling in an assembled view;
figure 5 shows a section of the application on the flexible PCB of the solder paste containing the soft solder alloy before the soldering;
figure 6 shows a sectional view of the soldering between the rigid PCB and the flexible PCB after the coupling was completed, with the melting of the soft solder alloy after the soldering;
figure 7 shows an example of a flexible PCB and a rigid PCB ready for coupling;
figure 8 shows a flexible-rigid PCB according to the invention;
figure 9 shows a solder meniscus of solder alloy coupling a flexible PCB and a rigid PCB.

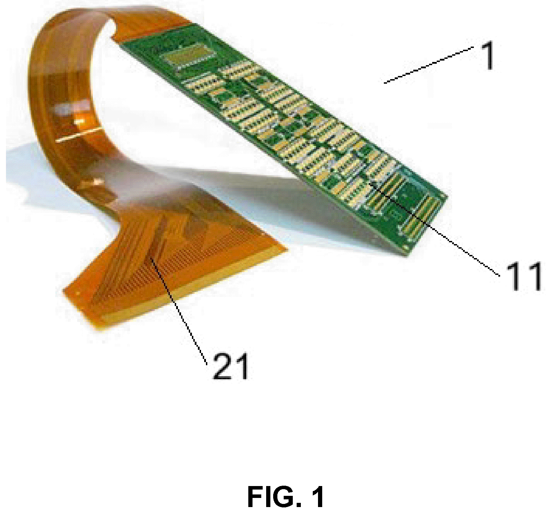

Figure 1 shows an example of a rigid-flexible PCB 1 according to the known art. In the figure, the rigid PCB 11 and the flexible PCB 21 are clearly visible.

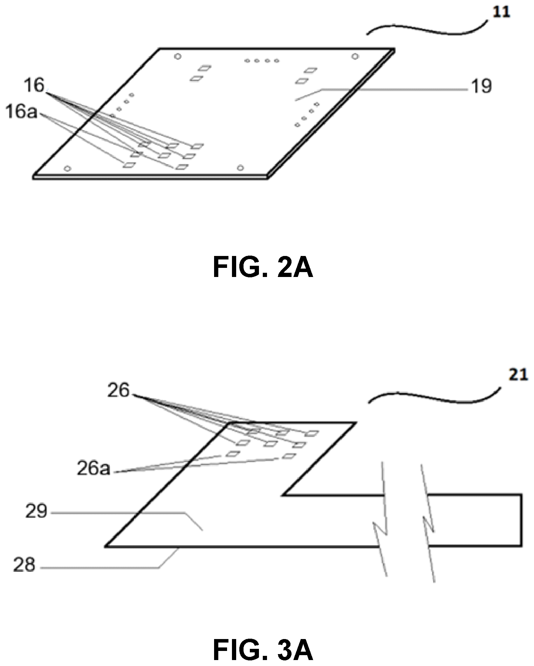

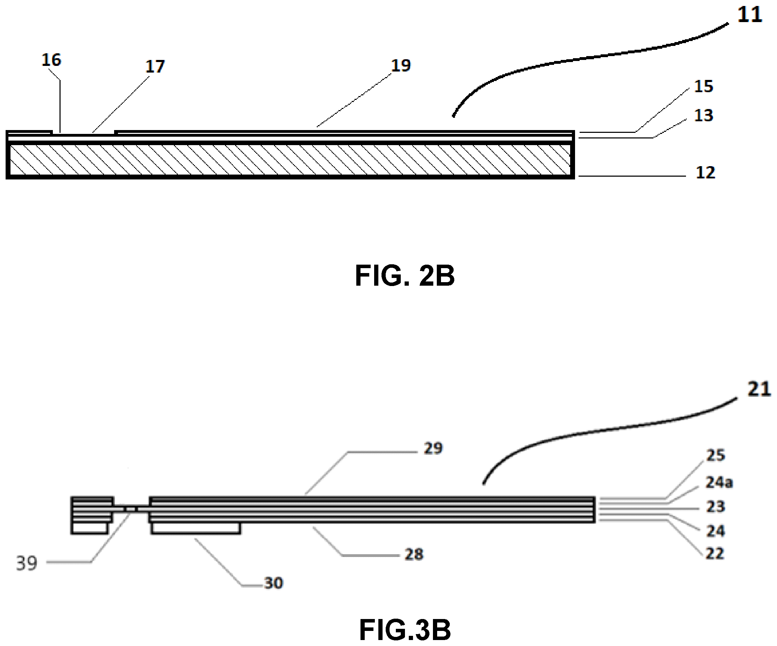

Figure 2 shows an example of a rigid PCB intended for coupling with the flexible PCB of figure 3; in particular, figure 2A shows an axonometric view and figure 2B shows a sectional view of said rigid PCB. Referring both to figure 2A and figure 2B, with 11 a rigid PCB according to known art is indicated, made of a rigid insulating substrate 12 typically made of mineral fibres embedded in an epoxy matrix and at least one conductive layer 13, typically made of copper. In practice, often rigid PCBs comprise more insulating layers and more conductive layers laminated together, to form so-called double-sided PCBs when the conductive layers are two, or multilayer PCBs when the conductive layers are more than two.

With 15 the external protective layer called solder resist is indicated, protecting the conductive tracks 13 from oxidation and from accidental contacts; such protective layer is open in correspondence with areas 16 intended for coupling through soldering, on which a protective solderable coating 17 is deposited, which can be of different nature, like a chemical deposition or a galvanic deposition of other metals, a tin alloy, a silver alloy, or a nickel and gold alloy, or a chemical deposition of organic products adjuvating the successive soldering.

For the sake of simplicity and of clarity, in the figures the rigid PCB 11 is represented with just one conductive layer, placed on the top face 19, case known as single-sided circuit; nonetheless, the present invention can be applied even in case of double-sided or multilayer circuits, well known in the art. In figures 2 electronic components mounted on the circuit are not shown.

Figure 3 shows an example of a flexible PCB intended for coupling to the rigid PCB of figure 2; in particular, figure 3A shows an axonometric view and figure 3B shows a sectional view of said flexible PCB. Referring both to figure 3A and figure 3B, with 21 a flexible PCB according to known art is indicated, made of a flexible insulating substrate 22 typically made of a polymer and at least one conductive layer 23, typically made of copper, in addition to the interposed adhesive. Flexible PCBs can comprise more insulating layer and more conductive layers laminated together, to form so-called double-sided PCBs when the conductive layers are two, or multilayer PCBs when the conductive layers are more than two. In an embodiment, in the case of multiple layers, the through holes 39 for interconnection are metallized, in order to connect the layers.

With 25 the external protective layer called solder resist is indicated, protecting the conductive tracks 23 from oxidation and from accidental contacts; such protective layer is usually made of the same type of material as the flexible substrate 22 optionally in a different thickness, in addition to the interposed adhesive 24a, and is open in correspondence with areas 26 intended for coupling through soldering, on which a protective solderable coating is deposited, which can be of different nature, like a chemical deposition or a galvanic deposition of other metals, a tin alloy, a silver alloy, or a nickel and gold alloy, or a chemical deposition of organic products adjuvating the successive soldering.

For the sake of simplicity and of clarity, in the figures the flexible PCB 21 is represented with just one conductive layer, accessible both from the top face 29 and from the bottom face 28 through suitable apertures obtained in the insulating supports 22 and 25. Nonetheless, the present invention can be applied even in case of double-sided or multilayer circuits, well known in the art. In figures 3 electronic components mounted on the circuit are not shown.

Finally, 30 indicates an optional adhesive layer, preferably in the form of double-sided adhesive, suitably positioned for adhering and keeping in position the flexible circuit 21, by setting the coupling areas 26 of the bottom face of the flexible PCB 21 in correspondence with the coupling areas 16 of the top face of the rigid PCB 11. Said adhesive 30 is punched or contour-cut so as to keep the flexible PCB in the correct position without covering the coupling areas 16, 26.

In an embodiment, the adhesive 30 intended for maintaining the two PCBs 11 and 21 in the desired position can be punched or contour-cut when it is applied to the flexible PCB 21. In an alternative embodiment, the adhesive can be replaced by a glue (not shown) applied to the rigid PCB 11, preferably through a doser. In fact, in SMT technology, often pick & place machines are used, provided with a doser meant for provided a glue point for fixing big and/or heavy components to be kept in position between their mounting and alloy melting; this technique can be advantageously exploited in the present invention.

In the case wherein the number of electrical connections between rigid PCB and flexible PCB is small, the mechanical connection between the two circuits 11, 21 could be insufficient. In an embodiment, according to shape, number, and dimensions of the respective soldering areas 16 and 26, further soldering areas 16a and 26a can be added, not supporting electrical connections, but only intended for increasing the mechanical robustness of the connection between the rigid PCB 11 and the flexible PCB 21.

In particular, the areas 26 intended for soldering on the flexible PCB must have a shape and a geometric disposition such as to mirror each other and be mutually corresponding to the areas 16 intended for soldering on the rigid PCB; moreover, said areas 26 must be free from the insulating substrate 22 and from the protective coating 25 so as to uncover the copper on both rigid and flexible PCBs, and must be provided with at least one through hole 39.

For the skilled person, it is obvious that the embodiments can be a wide plurality and even very different from those shown in the attached figures, as they depend on the specific application, e.g. concerning the shape and the dimension of soldering areas and the number of holes. The skilled person will perform a congruity check of the design with the requirements of electric connection and mechanical robustness, optionally increasing the number of holes and/or connection areas, should they prove to be insufficient.

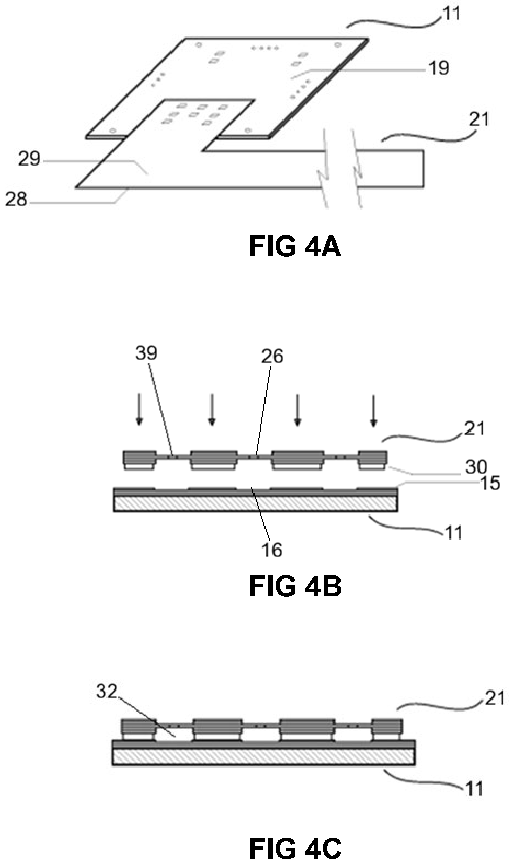

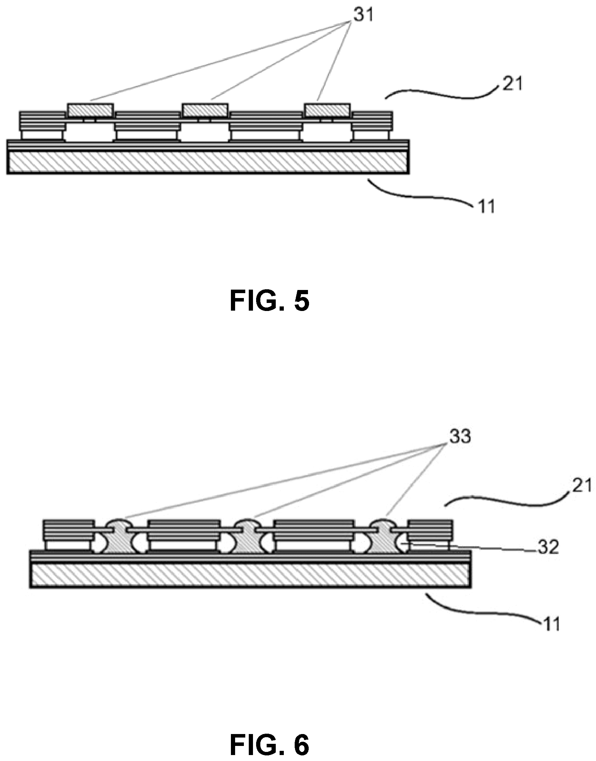

It is worth noting that the description of figures 4 and 5 refers specifically to the embodiment making use of solder paste. The embodiment providing the use of the solder paste in the form of wire is not shown in the figures, but is conceptually analogous to what is described for the embodiment with the solder alloy in the form of paste.

Figures 4 show the coupling of the rigid PCB 11 with the flexible PCB 21; in particular, figure 4A shows an axonometric view, figure 4B shows a sectional view wherein the two PCBs 11, 21 are still separate, while figure 4C shows a sectional view wherein the two PCBs 11, 21 are coupled in register.

In order to prepare the flexible PCB 21 to the coupling with the rigid PCB 11:
- in the flexible PCB 21 through holes 39 in the positions desired for contacts are obtained;
- in the rigid PCB 11 in the points corresponding to the through holes 39 the conductive layer is freed from solder resist 15.

As shown in figures 4, the rigid PCB 11 and the flexible PCB 21 must be placed in register, so that the positions of the coupling areas 16 and 26, and optionally of the supplementary areas 16a and 26a for the mechanical connection only, coincide. The coupling in register of the rigid PCB 11 and of the flexible PCB 21 are performed so that the areas intended for connection are mutually coupled.

Figure 5 shows the rigid PCB 11 and the flexible PCB coupled in register, in a sectional view. On the areas 26/26a of the flexible PCB, and hence in correspondence with holes 39 obtained in them, a solder paste 31 is applied, commonly in use for assembling electronic boards. Preferably, but not necessarily, such paste is applied through dosers or serigraphic methods.

Such solder paste is typically made of granules of solder alloy dispersed in a matrix of adjuvating resin. The solder alloy is typically based on tin, pure or in alloy with other metals. Until a few years ago, the solder alloy could comprise also heavy metals like lead; for the sake of safety, today this has become very rare, and tin-silver, tin-copper or even ternary tin-silver-copper alloys are preferred. Alternatively, pastes comprising so-called low-temperature solder alloys, comprising percentages of metals like indium or bismuth, e.g. tin - bismuth - copper or tin - bismuth - silver, etc. can be used.

The assembly formed by the rigid PCB 11 and the flexible PCB 21 on which the solder paste 31 has been deposited then undergoes a process of reflow soldering through common equipment for the production of PCBs, with the result of bringing to melting the solder alloy contained in the paste 31 and to the evaporation of the adjuvating resin; when melting, the alloy enters into the holes 39 of the flexible PCB between the areas 16/16a of the rigid PCB 11 and the areas 26/26a of the flexible PCB 21, connecting them both electrically and mechanically in a permanent way; moreover, a small quantity of melted alloy 31 will form a solder meniscus 33 in correspondence with the hole 39 on the flexible PCB 21, so making the success of the soldering evident through just a visual inspection.

As an alternative method, the soldering can be performed manually or using an automatic machine provided with a robotic arm (not shown); in both cases, as solder alloy the known solder wire is used, made of an alloy analogous to those mentioned above, wherein the adjuvating resin is co-extruded with the wire, forming a core inside the wire.

When the rigid-flexible PCB 100 is too big for the machines producing the plates of PCB in the traditional way, probably it is too big even for the machines assembling the electronic components (pick & place machines): hence, using the alternative technique of manual soldering or using an automatic machine and wire allows to obtain PCBs as large as desired. In this way, the step in the reflow oven is prevented; therefore, there is an advantage in terms of energy/cost of the process, and a thermal shock to the product is prevented.

It is worth noting that when the solder alloy melts, both in the form of paste and in the form of wire, two distinct cases can occur. When there is no space between the rigid PCB 11 and the flexible PCB 21, the melted solder paste connects the two circuits 11 and 21, forming a column having the dimensions of the hole 39, ensuring the electrical-mechanical connection. On the other hand, when the thickness of the base material 23 of the flexible PCB 21 and/or of the interposed adhesive or glue form a gap 32, the solder alloy 31 that underwent melting can fill this space up by penetrating by capillarity between the two conductive layers 13 and 23, ensuring anyway a good electrical-mechanical connection.

It is worth noting that the proposed method allows to realize rigid-flexible PCBs even with rigid PCBs based on alumina (Al₂O₃) or beryllium oxide (BeO), which being ceramic are fragile, and therefore cannot undergo pressing because they would break.

On the same rigid PCB more than one flexible PCB can be positioned, optionally even on both faces of the rigid PCB.

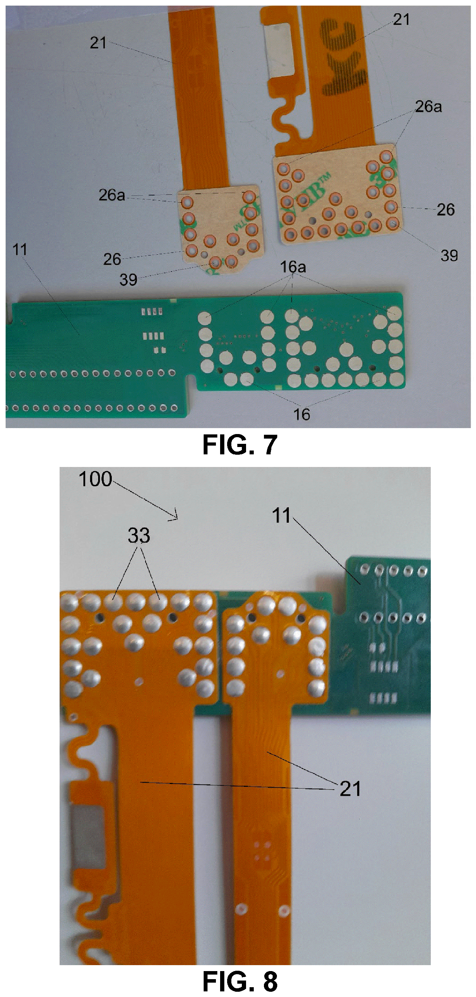

The method for making a rigid-flexible PCB according to the present invention comprises the following steps:
a) providing said rigid PCB 11 according to the known art, wherein in the portion intended for coupling suitable coupling areas 16 are provided having determined shape and dimensions;
b) providing said flexible PCB 21 according to the known art, wherein in the portion intended for coupling suitable coupling areas 26 are provided having determined shape and dimensions, mirroring those provided on the portion of the rigid PCB (see figure 7);
c) providing at least a through hole 39 for each coupling area in the areas intended for coupling of the flexible PCB 21;
d) placing said rigid PCB 11 and said flexible PCB 21 so that the coupling areas 16, 26 are kept in the correct reciprocal in register position,
e) applying on the coupling areas 16 intended for coupling a suitable quantity of solder alloy 31 and bringing it to melting, and successively cooling to room temperature.

It is worth mentioning that figure 7 shows a flexible PCB 21 wherein the protection liner was not removed from the adhesive 30, in that the adhesive 30 is thin and transparent, and without the adhesive liner it would be impossible to understand its position. In reality, such protection liner is removed before coupling.

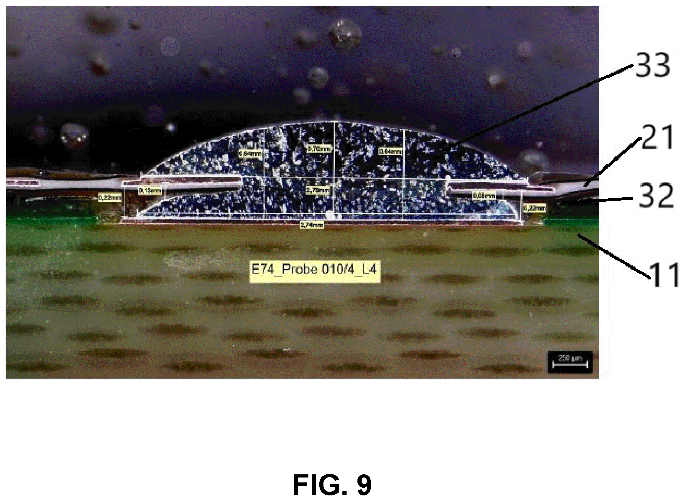

By using the above-described method, the solder alloy melts and forms a plurality of solder menisci 35, which can be visually inspected to verify that the two PCBs 11 and 21 are correctly and permanently assembled. An example of such solder menisci is shown in figure 8, wherein a plurality of solder menisci 33 of solder alloy 31 are shown. Said alloy, after undergoing melting, holds the rigid PCB 11 and the flexible PCB 21 forming the rigid-flexible PCB 100 according to the present invention. As can be observed in figure 9, the melted alloy while melting diffused by capillarity in the gap 32 between the rigid PCB 11 and the flexible PCB 21.

In an embodiment, the rigid PCB and the flexible PCB are kept in register through the interposition of an adhesive 30.

In an embodiment, the parts intended for coupling between the rigid PCB and the flexible PCB are coupled and held in a univocal position to each other during the subsequent processing steps through a mechanical coupling of any type (positioning in a template, coupling through pins, pressing, etc, or combinations thereof).

In an embodiment making use of the soldering paste, all the (not shown) electronic components requiring to be assembled through soft soldering are positioned on the rigid and/or flexible PCB, the two PCBs are coupled and the melting of the solder paste is performed in just one go, obtaining in just one processing step all the final rigid-flexible PCB.

In an alternative embodiment making use of solder paste, the (not shown) electronic components are positioned, a first melting of the solder paste is performed separately obtaining the rigid PCB and the flexible PCB; successively, the two PCBs are coupled and the melting of the solder paste is performed in a second step, using a solder paste with a lower melting temperature. E.g., if in the first step a solder paste with a melting temperature of 280°C was used, in the second step a solder paste with a melting temperature of 180°C is used, so as to prevent the detaching of the previously assembled components.

The realization of prototypes and the mechanical and electrical tests performed in the laboratory have shown the efficacy and the reliability of the present invention and have detected features comparable with those of the analogous product obtained through the known art.
- 11: rigid PCB
- 12: insulating substrate
- 13: conductive layer
- 15: external protective layer (solder resist)
- 16: soldering areas
- 16a: mechanical soldering areas
- 17: protective coating
- 19: top face of the rigid PCB
- 21: flexible PCB
- 22: insulating substrate
- 23: conductive layer
- 24: adhesive layer
- 24a: adhesive layer
- 25: external protective coating
- 26: soldering areas
- 26a: mechanical soldering areas
- 28: bottom face of the flexible PCB
- 29: top face of the flexible PCB
- 30: adhesive layer
- 31: solder alloy
- 32: gap
- 33: solder meniscus
- 39: through layer
- 100: rigid-flexible PCB according to the invention

## Claims

1. Rigid-flexible Printed Circuit Board or PCB (100) for electronic applications, provided with conductive tracks, insulating layer, protective coating, optionally electronic components, comprising:
- at least one rigid PCB (11) and
- at least one flexible PCB (21) capable of elastic deformation; when said flexible PCB undergoes a mechanical stress, it returns to its original shape when the applied stress is removed without any damage,
comprising:
- at least one coupling area (16) of the rigid PCB (11) and at least one coupling area (26) of the flexible PCB (21), positioned and coupled in register, said areas (16, 26) being free from insulating layer (12, 22) and from protective coating (15, 25) so that a conductive layer (13, 23) is uncovered in both PCBs (11, 21);
- at least one through hole (39) in said coupling area (26) of the flexible PCB (21);
- a mirroring pattern of the coupling areas (16, 26) in overlaying portions of rigid PCB and of flexible PCB;
- at least one point of mechanical and electrical connection (23) between said two flexible PCB (21) and rigid PCB (11) realized in correspondence with said at least on through hole (39) through melted solder alloy (31);
**characterized in that**
said coupling areas between said flexible PCB (21) and rigid PCB (11) comprise further soldering areas (16a, 26a) which do not support electrical connections, but increase the mechanical robustness of the connection between the rigid PCB (11) and the flexible PCB (21).

2. Rigid-flexible PCB (100) for electronic applications according to claim 1, wherein in the portion intended for coupling between rigid PCB (11) and flexible PCB (21) and out of said at least one electrical and mechanical connection point (23) and from said further soldering areas (16a, 26a), a layer of adhesive or glue is interposed, for keeping said rigid PCB (11) and said flexible PCB (21) in a univocal position.

3. Rigid-flexible PCB (100) for electronic applications according to claim 1 or 2, wherein said at least one through hole (39) is metallized.

4. Rigid-flexible PCB (100) for electronic applications according to one or more of the preceding claims, wherein said rigid PCB (11) is formed by at least a rigid insulating layer (12) and at least one conductive layer (13).

5. Rigid-flexible PCB (100) for electronic applications according to claim 4, wherein said at least one conductive layer (13) is provided with an external protective layer (15).

6. Rigid-flexible PCB (100) for electronic applications according to one or more of the preceding claims, wherein said flexible PCB (21) is formed by at least a flexible insulating substrate (22) and at leas by a conductive layer (23).

7. Rigid-flexible PCB (100) for electronic applications according to claim 6, wherein said at least conductive layer is provided with an external protective layer (25).

8. Rigid-flexible PCB (100) for electronic applications according to claim 4, wherein the substrate of the rigid PCB consists in a ceramic material, preferably based on alumina (Al2O3) or beryllium oxide (BeO).

9. Rigid-flexible PCB (100) for electronic applications according to one or more of the preceding claims, wherein said rigid PCB (11) is assembled with at least two flexible PCBs (21), optionally on both sides of said rigid PCB (11).

10. Method for making a rigid-flexible PCB according to one or more of claims 1-9, **characterized by** comprising the following steps:
a) providing at one least rigid PCB (11), wherein, in a portion intended for coupling (16), coupling areas are provided having determined shape and dimensions;
b) providing at least one flexible PCB (21), wherein, in a portion intended for coupling, coupling areas (26) are provided having determined shape and dimensions, mirroring those provided on the coupling portion of the rigid PCB (11);
c) providing in the areas (26) of the flexible PCB (21) intended for the mechanical and electric coupling areas of the rigid PCB (11) at least a through hole (39);
d) placing said rigid PCB (11) and said flexible PCB (21) so that the coupling areas (16, 26) are kept in the correct reciprocal in-register position,
e) applying on the coupling areas (16, 26) of the rigid PCB (11) and of the flexible PCB (21) intended for electrical and mechanical coupling a suitable quantity of solder alloy (31);
f) bringing said solder alloy to melting, and successively cooling to room temperature.

11. Method for making a rigid-flexible PCB according to one or more of claims 1-9, **characterized by** comprising the following steps:
a) providing at least one rigid PCB (11), wherein, in a portion intended for coupling (16), coupling areas are provided having determined shape and dimensions;
b) providing at least one flexible PCB (21), wherein, in a portion intended for coupling, coupling areas (26) are provided having determined shape and dimensions, mirroring those provided on the coupling portion of the rigid PCB (11);
c) providing in the areas (26) of the flexible PCB (21) intended for the mechanical and electric coupling areas of the rigid PCB (11) at least a through hole (39);
d) applying on the coupling areas (16, 26) of the rigid PCB (11) and of the flexible PCB (21) intended for electrical and mechanical coupling a suitable quantity of solder alloy (31);
e) placing said rigid PCB (11) and said flexible PCB (21) so that the coupling areas (16, 26) are kept in the correct reciprocal in-register position,
f) bringing said solder alloy to melting, and successively cooling to room temperature.

12. Method for making a rigid-flexible PCB according to claim 10 or 11, wherein, before the in-register positioning and coupling, in the coupling areas (16, 26) for electrical and mechanical connections further coupling areas (16a, 26a) provided with solder alloy are added, said further coupling areas (16a, 26a) being intended to increase the mechanical robustness of the connection between said rigid PCB (11) and flexible PCB (21).

13. Method for making a rigid-flexible PCB according to claim 11 or 12, wherein said solder alloy is applied in the form of solder paste, preferably through a doser or serigraphy.

14. Method for making a rigid-flexible PCB according to any of claims 10-13, wherein electronic components assemblable through soldering are positioned on the rigid PCB and/or flexible PCB, said two PCBs (11, 21) are coupled and the melting of the solder paste is performed just once, realizing in one step the finished rigid-flexible PCB.

15. Method for making a rigid-flexible PCB according to any of claims 10-13, wherein electronic components assemblable through soldering are positioned on the rigid PCB and/or flexible PCB, a first melting of said solder paste is performed so obtaining separately PCBs (11, 21); successively, said two PCBs are coupled and the melting of the solder paste is performed in a second step, using a solder paste having a melting temperature lower than that previously used.

16. Method for making a rigid-flexible PCB according to claims 10 or 12, wherein the solder alloy is applied under the form of solder wire, manually positioned or positioned through an automatic machine preferably provided with a robotic arm.

17. Method for making a rigid-flexible PCB according to any of claims 10 or 11-15, wherein electronic components assemblable through soldering are positioned on the rigid PCB and/or flexible PCB, a first melting of said solder paste is performed so obtaining two separate PCBs (11, 21); successively, said two PCBs are coupled and the soldering is manually performed manually or through an automatic machine preferably provided with a robotic arm.

18. Method for making a rigid-flexible PCB according to one or more of claims 10-17, wherein during the coupling between rigid PCB (11) and flexible PCB (21) a layer of adhesive or glue is interposed, said adhesive or glue being intended for keeping said rigid PCB (11) and flexible PCB (21) in a univocal position during the following working steps.

19. Method for making a rigid-flexible PCB according to one or more of claims 10-17, wherein during the coupling between rigid PCB (11) and flexible PCB (21) a mechanical coupling means is used.
